# FASCICULE DE BREVET EUROPEEN

(11) **EP 1 246 197 B1**
(45) Date de publication et mention de la délivrance du brevet: **28.05.2008**
(21) Numéro de dépôt: 02366003.8
(22) Date de dépôt: 05.03.2002
(51) Int. Cl.: G11C 16/12

(54) **Circuit et procédé associé d'effacement ou de programmation d'une cellule mémoire**
Schaltung und Verfahren zum Löschen oder Programmieren einer Speicherzelle
Circuit and method for erasing or programming a memory cell

(30) Priorité: 12.03.2001 FR 0103284
(43) Date de publication de la demande: 02.10.2002
(73) Titulaire: STMicroelectronics S.A., 92120 Montrouge (FR)
(72) Inventeur: Naura, David, 57070 Metz (FR); Bertrand, Bertrand, 57070 Metz (FR); Chehadi, Mohamad, 57070 Metz (FR)
(74) Mandataire: Bentz, Jean-Paul

(56) Documents cités:
- EP-A- 0 762 428
- EP-A- 0 903 750
- FR-A- 2 770 326

## Description

L'invention concerne un circuit et un procédé associé d'effacement ou de programmation d'une cellule mémoire. L'invention est notamment intéressante pour des mémoires de type non volatile, électriquement programmables et effaçables, par exemple des mémoires de type EEPROM, flash EPROM, etc.

Le composant principal d'une cellule mémoire de ces mémoires est un transistor de mémorisation de type à grille flottante comprenant un drain, une source, une grille de commande et une grille flottante qui mémorise une information. La programmation d'une cellule mémoire est le plus souvent réalisée en deux étapes : une étape d'effacement suivie d'une étape d'écriture.

Pour réaliser une étape d'effacement de la cellule mémoire, on applique par exemple une haute tension sur la grille de commande du transistor de mémorisation et une tension nulle sur son drain et sur sa source. Ainsi, la différence de potentiel entre la grille de commande et le drain du transistor de mémorisation entraîne la création d'un champ électrique entre la grille de commande et le drain, qui a pour conséquence la migration d'électrons depuis la source et le drain vers la grille flottante et donc la décharge de la grille flottante.

Inversement, pour réaliser une étape d'écriture de la cellule mémoire, on applique une tension nulle sur la grille de commande du transistor de mémorisation et une haute tension sur son drain, sa source étant portée à un potentiel flottant. La différence de potentiel entre la grille de commande et le drain du transistor de mémorisation entraîne la création d'un champ électrique de polarité opposée, qui a pour conséquence la migration d'électrons en sens inverse, depuis la grille flottante du transistor de mémorisation vers son drain.

Pour réaliser une étape d'écriture ou d'effacement de la cellule mémoire, il est ainsi nécessaire de disposer d'une haute tension d'effacement ou de programmation, de l'ordre de 15 à 20 V, qui est appliquée sur l'une ou l'autre des électrodes du transistor de mémorisation de la cellule mémoire, selon l'opération à effectuer.

Cependant, la couche d'oxyde comprise entre la grille flottante et le drain du transistor de mémorisation est peu épaisse et fragile. Aussi, lorsque la tension appliquée sur les électrodes du transistor de mémorisation est supérieure à une tension dite tunnel, elle ne doit pas varier brutalement. En effet, une variation brutale de la tension entraîne la création d'un courant important entre la grille flottante et le drain ou la source du transistor. Un courant trop important entraînerait une fragilisation, voire une détérioration de la couche d'oxyde.

On rappelle que la tension tunnel est la tension minimale nécessaire pour qu'une charge transite par effet tunnel à travers la couche d'oxyde, entre la grille flottante et le drain d'un transistor à grille flottante. Typiquement, la valeur de la tension tunnel est de l'ordre de 10 V.

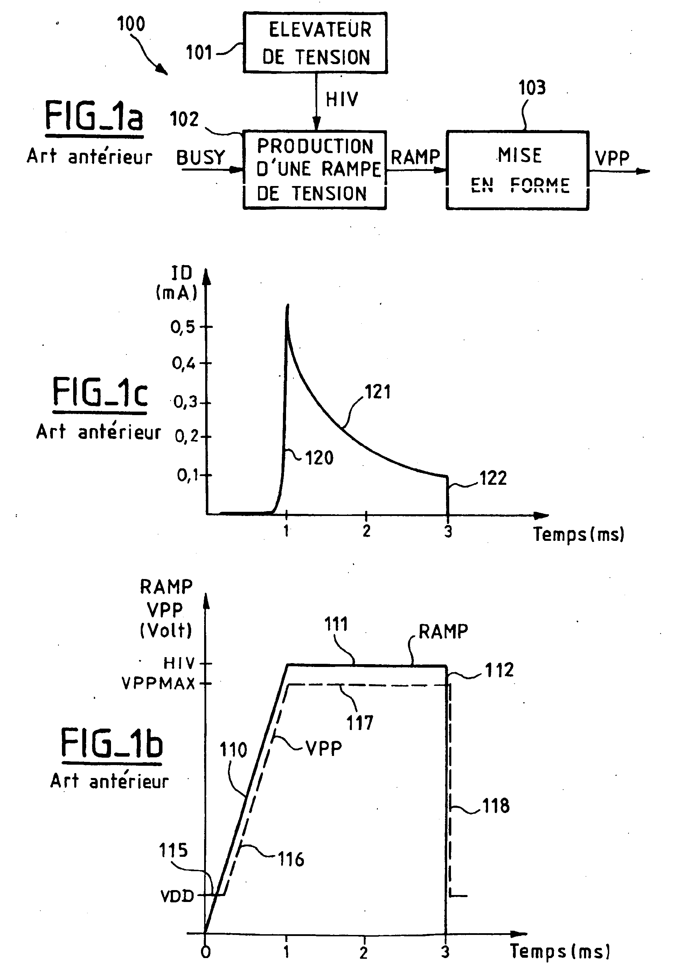

Pour obtenir une tension variant progressivement et lentement, on utilise classiquement un circuit d'effacement ou de programmation dont un exemple connu est présenté schématiquement sur la figure 1a ; il comprend un élévateur de tension 101, un circuit 102 de production d'une rampe de tension et un circuit 103 de mise en forme, tous trois alimentés par une basse tension d'alimentation VDD (non représentée sur la figure 1a), de l'ordre de 2 à 3 V pour une technologie 0,25 µm.

Le circuit élévateur de tension 101 est par exemple de type pompe de charge ; il produit une haute tension HIV de l'ordre de 15 à 20 V à partir de la basse tension d'alimentation VDD.

Le circuit 102 produit, à partir de la haute tension HIV, une tension en rampe RAMP, qui a par exemple la forme représentée en trait continu sur la figure 1b. Elle comprend :
- une phase ascendante 110 au cours de laquelle la tension RAMP augmente de façon continue jusqu'à sa valeur maximale VMAX, qui est par exemple égale à la haute tension HIV,
- un plateau de tension 111 pendant lequel la tension RAMP est constante, égale à la valeur VMAX,
- une chute de tension 112.

Le circuit de génération de rampe 102 comprend classiquement un circuit de charge et de décharge d'un condensateur de puissance ; ce circuit est alimenté par une source de courant qui fournit un courant de référence IREF. La phase ascendante 110 de la tension RAMP est obtenue en chargeant un condensateur avec un courant de charge ICH. Le plateau de tension 111 est quant à lui obtenu par la décharge de ce même condensateur avec un courant de décharge IDECH.

Les courants de charge et / ou de décharge utilisés sont le plus souvent, mais pas nécessairement, proportionnels à IREF et constants. Ils sont le plus souvent différents l'un de l'autre. La phase ascendante 110 peut être plus longue ou plus courte que le plateau de tension 111, selon la valeur du courant ICH par rapport à celle du courant IDECH.

La phase ascendante 110 et le plateau de tension 111 ont une durée totale TRAMP qui correspond à la durée d'une opération d'effacement (ou de programmation).

Un choix convenable de la capacité du condensateur ainsi que du courant de référence IREF permet d'optimiser la pente de la phase ascendante 110 ainsi que la durée totale TRAMP. Ce choix est en général un compromis fait à partir des critères suivants :
- lorsque la tension appliquée sur les électrodes du transistor de mémorisation est supérieure à la tension tunnel, elle ne doit pas varier brutalement comme on l'a vu précédemment. Pour cela, la pente de la phase ascendante 110 ne doit pas dépasser une valeur limite.
- la durée totale TRAMP doit être suffisamment longue pour que la tension RAMP ait le temps d'atteindre sa valeur maximale VMAX,
- le plateau de tension doit durer suffisamment longtemps pour assurer la réalisation complète d'une étape d'effacement ou de programmation,
- la durée totale TRAMP doit être la plus faible possible.

Le circuit de mise en forme 103 reçoit la tension RAMP et produit une haute tension d'effacement ou de programmation VPP qui est appliquée sur l'une ou l'autre les électrodes d'une cellule mémoire (non représentée figure 1a), selon qu'une programmation ou un effacement de la cellule mémoire est envisagé.

La haute tension d'effacement ou de programmation VPP a par exemple la forme représentée en tirets sur la figure 1b ; elle comprend :
- un premier plateau de tension 115, pendant lequel la tension VPP est égale à la basse tension d'alimentation VDD,
- une phase ascendante 116 suivie d'un second plateau de tension 117, la tension VPP est ici égale à la tension RAMP, à une chute de tension VTN près dans un transistor,
- une chute de tension 118, au cours de laquelle la tension VPP redescend à la valeur VDD.

La tension VPP suit ainsi les variations de la tension RAMP, à une chute de tension VTN près, de l'ordre de 2 V, qui correspond approximativement à la tension de seuil de conduction d'un transistor de type N.

Lors d'une programmation d'une cellule mémoire, une tension nulle est appliquée sur la grille de commande du transistor à grille flottante, une tension égale à VPP est appliquée sur le drain du transistor et sa source est laissée à un potentiel flottant. Le courant ID circulant entre le drain et la source du transistor a dans ce cas l'allure représentée sur la figure 1c.

Le courant ID est nul lorsque la tension VPP est croissante et inférieure à la tension tunnel, puis il croît brutalement (réf. 120) depuis une valeur nulle jusqu'à une valeur maximale IDMAX lorsque VPP dépasse la tension tunnel. La valeur IDMAX est atteinte lorsque VPP atteint sa valeur maximale VPPMAX. Le courant ID redescend ensuite (réf. 121) pendant toute la durée du plateau 117, puis il chute brutalement à zéro (réf. 122) lorsque la tension VPP chute (118) à sa valeur minimale VDD.

Lors d'un effacement de la cellule mémoire, le courant circulant entre le drain et la source a une allure similaire, il circule simplement en sens inverse par rapport au cas d'une programmation.

Un autre exemple d'un circuit d'effacement ou de programmation est divulgué dans EP-A-0 762 428.

Le temps d'effacement TER (ou de programmation TWR) de la cellule mémoire est de l'ordre de TRAMP, environ 3 ms. Le temps d'effacement ou de programmation d'une cellule mémoire est ainsi relativement long, ce qui peut être particulièrement dommageable dans certains cas.

Par exemple, lors de la fabrication des mémoires, toutes les cellules de la mémoire sont soumises notamment à un test d'endurance, consistant généralement à exécuter successivement plusieurs opérations (de l'ordre de 500 opérations) d'effacement et / ou de programmation, pour vérifier si les cellules ont été correctement réalisées ou pas, et si elles vérifient les spécifications demandées en matière de résistance à l'usage notamment.

Ce test d'endurance représente seulement un test parmi l'ensemble des tests effectués lors de la réalisation d'une mémoire, cependant ce seul test est particulièrement long puisqu'il dure environ 2 s, ce qui représente environ la moitié de la durée totale d'une phase complète de test d'une mémoire.

Un but de l'invention est de diminuer les temps d'effacement ou de programmation d'une cellule mémoire sans nuire à la qualité de la cellule. Ceci permettra notamment de réduire de manière importante la durée du test d'endurance d'une mémoire en sortie de chaîne de production.

L'invention concerne ainsi un circuit de production d'une tension d'effacement ou de programmation d'une cellule mémoire, comprenant un condensateur, et un circuit de décharge connecté à une première borne du condensateur pour décharger le condensateur.

Selon l'invention, le circuit de décharge du condensateur comprend :
- un premier transistor, dont un drain est connecté à la première borne du condensateur, pour activer le circuit de décharge lorsqu'un signal de décharge est appliqué sur la grille de commande du premier transistor,
- une branche de décharge lente connectée à la source du premier transistor, pour produire un faible courant de décharge du condensateur lorsque le signal de décharge est reçu, et
- une branche de décharge rapide, connectée à la source du premier transistor, pour produire un courant de décharge rapide du condensateur lorsque le signal de décharge et un signal de sélection d'un mode de fonctionnement sont reçus simultanément.

Ainsi, selon l'invention, on utilise un courant de décharge IDECH qui prend deux valeurs. Ceci permet, selon la valeur utilisée, de conserver ou de réduire (voire de supprimer) le plateau des tensions RAMP, VPP, puisque la durée du plateau est proportionnelle à la valeur du courant IDECH. Le choix de l'une ou l'autre des valeurs du courant IDECH est fait par l'utilisateur.

Le circuit de production d'une tension d'effacement ou de programmation d'une cellule mémoire selon l'invention fonctionne de la manière suivante.

Il est activé lorsqu'il reçoit le signal de décharge. De plus, si aucun signal de sélection de mode n'est reçu, le circuit selon l'invention est dans un mode de fonctionnement standard, et son fonctionnement dans ce cas est similaire à celui d'un circuit selon l'art antérieur. En particulier, la décharge du condensateur s'effectue, lorsque le signal de décharge est reçu, dans des conditions similaires à celle d'un condensateur d'un circuit selon l'art antérieur et la durée du plateau correspondant est du même ordre de grandeur. On choisit pour cela un courant de décharge lente du même ordre de grandeur que le courant de décharge utilisé dans un circuit selon l'art antérieur.

Par contre, si un signal de sélection est reçu, alors le circuit selon l'invention est dans un mode de fonctionnement spécifique. Dans ce cas, on décharge très rapidement le condensateur, pour réduire ou supprimer la phase de plateau et réduire ainsi le temps d'effacement ou de programmation. La branche de décharge rapide fournit pour cela le fort courant de décharge, qui est par exemple 20 à 40 fois le faible courant de décharge produit par la branche de décharge lente.

En réduisant ou supprimant le plateau, on réduit bien sûr d'autant la durée d'une étape d'effacement ou de programmation d'une cellule mémoire. En choisissant un fort courant de décharge adéquat, on peut ainsi diminuer par deux la durée d'une telle étape.

Il est à noter que, dans le cas d'une suppression complète du plateau, l'effacement ou la programmation d'une cellule n'est assuré qu'à 70% environ. Ceci peut être gênant pour certaines applications, mais pas pour toutes.

Par exemple, dans un mode de fonctionnement normal d'une cellule mémoire, il est important d'assurer une programmation complète, afin d'assurer d'une part une bonne conservation des données dans le temps, et d'autre part une réalisation correcte d'une éventuelle lecture.

Inversement, pour réaliser un test d'endurance sur une cellule mémoire, il n'est pas indispensable d'assurer un effacement ou une programmation complète de la cellule. Il suffit que la tension de d'effacement ou de programmation appliquée et le courant dans la cellule créé par cette tension atteignent leurs valeurs maximales : l'objectif de ce test est en effet seulement de voir le comportement dans le temps de la cellule lorsqu'elle supporte une forte tension et / ou un fort courant.

Le circuit de production d'une tension d'effacement ou de programmation d'une cellule mémoire de l'invention permet ainsi de réaliser différents types d'effacement ou de programmation de cellules mémoire, dans les meilleures conditions possibles, notamment en terme de temps, de tensions appliquées, de courant créés, etc.

La branche de décharge lente comprend par exemple un deuxième transistor, dont un drain est connecté à la source du premier transistor et dont une source est connectée à une masse du circuit, le faible courant de décharge étant proportionnel à un courant de référence appliqué sur la grille de commande du deuxième transistor. Le deuxième transistor peut également être remplacé par une série de transistors associés en parallèle.

La branche de décharge rapide comprend par exemple :
- un troisième transistor, dont un drain est connecté à la source du premier transistor, le signal de sélection de mode étant appliqué sur la grille de commande du troisième transistor, et
- un quatrième transistor, dont un drain est connecté à une source du troisième transistor et dont une source est connectée à la masse du circuit, le courant de référence étant appliqué sur la grille de commande du quatrième transistor. Le quatrième transistor peut également être remplacé par une série de transistors associés en parallèle.

La taille (en terme de rapport longueur sur la largeur de grille W/L) du quatrième transistor est supérieure à la taille du deuxième transistor. Ainsi, le courant qui traverse le quatrième transistor, lorsqu'il est passant, est supérieur à celui qui traverse le deuxième transistor. Par exemple, la taille du quatrième transistor est 10 à 100 fois supérieure à la taille du deuxième transistor.

Selon un autre mode de réalisation de l'invention, le circuit de production d'une tension d'effacement ou de programmation d'une cellule mémoire comprend également un circuit de charge, connecté à une deuxième borne du condensateur pour charger le condensateur, qui comporte :
- une branche de charge lente connectée à la deuxième borne du condensateur, pour produire un faible courant de charge lorsque un signal d'activation est reçu, et
- une branche de charge rapide, connectée à la deuxième borne du condensateur, pour produire un fort courant de charge du condensateur si le signal de sélection de mode et un signal de niveau de tension sont reçus simultanément, le signal de niveau de tension indiquant qu'une tension d'effacement ou de programmation fournie par le circuit de production d'une tension d'effacement ou de programmation est inférieure à une tension de seuil.

On obtient ainsi une charge du condensateur, et donc une croissance de la tension d'effacement ou de programmation, qui varie selon le mode de fonctionnement du circuit :
- lorsque le signal de sélection de mode est inactif, la croissance de la tension de programmation ou d'effacement est lente, selon une seule pente,
- lorsque le signal de sélection de mode est actif, la croissance de la tension de programmation ou d'effacement est effectuée selon deux pentes : une pente rapide lorsque la tension d'effacement ou de programmation est inférieure à une valeur seuil, et une pente lente sinon. Ainsi, lorsque la tension devient supérieure à la valeur seuil, sa croissance est similaire à celle d'un fonctionnement standard (signal de sélection de mode inactif).

Ceci permet de ne pas varier trop rapidement la tension appliquée sur les oxydes de la cellule mémoire lorsque cette tension a dépassé la tension tunnel de la cellule.

Selon un autre mode de réalisation encore, le circuit de production d'une tension d'effacement ou de programmation de l'invention comprend également :
- un circuit de génération d'une rampe de tension, pour produire une rampe de tension, à partir des potentiels sur la première borne et la deuxième borne du condensateur, et
- un circuit de mise en forme, comprenant un huitième transistor, une haute tension étant appliquée sur une borne du huitième transistor, et la tension d'effacement ou de programmation étant fournie sur une autre borne du huitième transistor. Le huitième transistor est choisi de préférence de type P : la tension d'effacement ou de programmation peut ainsi atteindre la valeur de la haute tension puisque un tel transistor de type P ne présente pas de chute de tension à ses bornes lorsqu'il est passant.

Enfin, l'invention concerne également un procédé de production d'une tension d'effacement ou de programmation d'une cellule mémoire, au cours duquel on charge un condensateur en appliquant un courant de charge sur une deuxième borne au cours d'une première étape, puis on décharge le condensateur en appliquant un courant de décharge sur une première borne du condensateur au cours d'une deuxième étape.

Selon l'invention, au cours de la deuxième étape, le courant de décharge prend une faible valeur ou une forte valeur supérieure à la première valeur, en fonction d'un mode de fonctionnement.

L'invention sera mieux comprise et d'autres caractéristiques et avantages apparaîtront à la lecture de la description qui va suivre, d'un exemple de mise en oeuvre d'un circuit d'effacement ou de programmation selon l'invention. La description est à lire en relation aux dessins annexés dans lesquels :
- la figure 1a est un schéma fonctionnel illustrant un circuit d'effacement ou de programmation d'une cellule mémoire, selon l'art antérieur,
- les figures 1b, 1c sont des diagrammes temporels montrant des signaux à certains points du circuit d'effacement ou de programmation de la figure 1a,
- la figure 2 est un schéma fonctionnel illustrant un circuit d'effacement ou de programmation, selon l'invention,
- la figure 4 est un schéma électronique illustrant certains éléments du schéma de la figure 2,

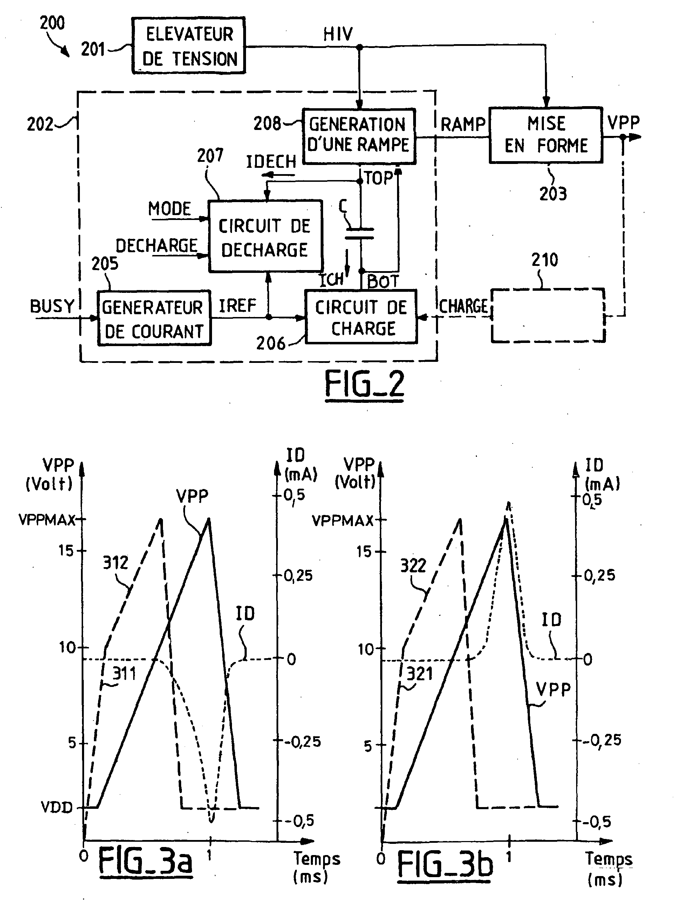

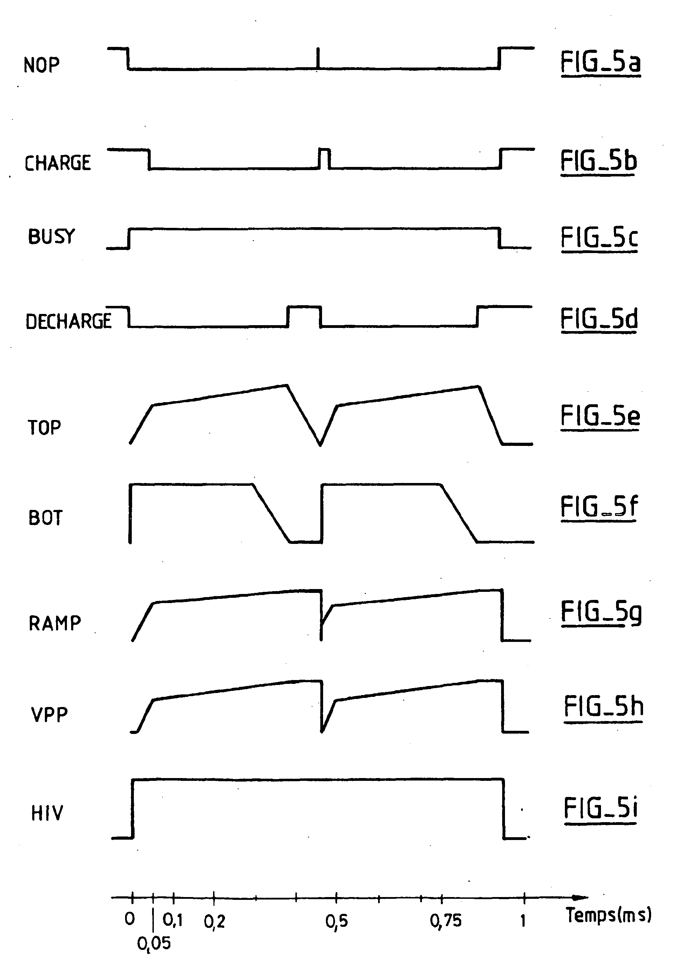

- les figures 3, 5a à 5i sont des diagrammes temporels des signaux à certains points du circuit de la figure 2.

Les figures 1a à 1c correspondent à un état de la technique connu et ont été précédemment décrites. Elles ne seront par détaillées ci-dessous.

Le circuit 200 de production d'une tension d'effacement ou de programmation selon l'invention comprend un élévateur de tension 201, un circuit de production d'une rampe de tension 202 et un circuit de mise en forme 203.

L'élévateur de tension 201 est par exemple identique à celui utilisé dans le circuit de la figure la, il produit une haute tension continue et stable HIV constante, de l'ordre de 20 V. Le circuit 201 est activé par un signal d'activation BUSY (non représenté) fourni par un circuit de commande extérieur.

Le circuit de production d'une rampe de tension 202 produit une tension en rampe RAMP, à partir de la haute tension HIV. Le circuit 202 est activé par le signal d'activation BUSY, fourni par un circuit extérieur.

Le circuit 202 comprend un condensateur C, un générateur de courant 205, un circuit 206 de charge du condensateur C, un circuit 207 de décharge du condensateur C, et un circuit de génération d'une rampe de tension 208.

Le générateur de courant 205 produit, sur une borne de sortie, un courant de référence IREF constant lorsqu'il est activé par le signal BUSY, appliqué sur une borne d'entrée de commande du générateur de courant 205.

Le condensateur C est un condensateur de puissance, ayant une capacité de l'ordre de 5 à 10 pF.

Le circuit de charge 206 comprend une borne d'entrée connectée à la borne de sortie du générateur de courant 205 et une borne de sortie connectée à un pôle du condensateur C sur lequel est produit un potentiel BOT. Le circuit de charge 206 produit un courant de charge ICH à partir du courant de référence IREF, le courant ICH étant utilisé pour charger le condensateur C. ICH est ici constant et proportionnel à IREF.

Le circuit de décharge 207 comprend une borne d'entrée connectée à la borne de sortie du générateur de courant 205, deux bornes d'entrée de commande sur lesquelles sont appliqués deux signaux de commande DECHARGE, MODE et une borne de sortie connectée à l'autre pôle du condensateur C sur lequel est produit un potentiel TOP. Le circuit de décharge 206 produit un courant de décharge IDECH à partir du courant de référence IREF et des signaux de commande DECHARGE, MODE, le courant IDECH étant utilisé pour décharger le condensateur C. IDECH ici est proportionnel à IREF et il varie de la manière suivante, en fonction des signaux de commande DECHARGE, MODE :
IDECH = 0 si DECHARGE = 0
IDECH = IDECH0 si DECHARGE = 1 et MODE = 0
IDECH = IDECH1 si DECHARGE = 1 et MODE = 1

Le signal DECHARGE est ainsi utilisé pour activer le circuit de décharge 207, et le signal MODE permet de choisir entre deux valeurs IDECH0, IDECH1 possibles pour le courant de décharge IDECH, en fonction d'un mode de fonctionnement choisi.

IDECH1 est choisi supérieur à IDECH0, voire très supérieur à IDECH0. Par exemple, IDECH0 est choisi de l'ordre de IREF, et IDECH1 est choisi de l'ordre de 10 à 100 fois le courant IREF. Les courants IDECH0, IDECH1 sont fixés lors de la réalisation du circuit.

Le circuit 208 de génération d'une rampe de tension produit une tension RAMP à partir de la haute tension HIV, et des potentiels BOT, TOP aux pôles du condensateur C. La tension RAMP varie de la manière suivante :
- Au cours d'une première phase (phase de croissance), la tension RAMP est croissante, selon une pente proportionnelle au courant de charge ICH du condensateur C,
- Au cours d'une deuxième phase (phase de plateau), la tension RAMP est constante, la durée de cette deuxième phase étant proportionnelle à la valeur du courant de décharge IDECH utilisé, ainsi :

- Si MODE = 0, alors le courant IDECH est égal à IDECH0 et la durée du plateau est dans ce cas du même ordre de grandeur que la durée de la phase de croissance ou que la durée de la phase de plateau lorsqu'un circuit selon l'art antérieur est utilisé. La durée de la phase de plateau est ainsi de l'ordre de 1 ms. Par contre,
- Si MODE = 1, alors le courant IDECH est égal à IDECH1 et la durée du plateau est plus courte. Le plateau disparaît même complètement si la valeur IDECH1 est très supérieure à IDECH0.

En d'autres termes :
- Si MODE = 0, le fonctionnement du circuit selon l'invention est similaire à celui d'un circuit selon l'art antérieur,
- si MODE = 1 par contre, on décharge très rapidement le condensateur C, pour réduire ou supprimer la phase de plateau et réduire ainsi le temps d'effacement ou de programmation.

Enfin, le circuit de mise en forme 203, activé par le signal BUSY (non représenté figure 2) produit la tension d'effacement ou de programmation VPP à partir de la tension RAMP. La tension VPP varie de la manière suivante :
- si BUSY est actif : VPP = VDD si RAMP < VDD et VPP = RAMP si RAMP ≥ VDD
- si BUSY est inactif : VPP = VDD.

Le fonctionnement du circuit de la figure 2 va maintenant être décrit en relation avec les diagrammes des figures 3a et 3b, qui montrent l'évolution de la tension VPP appliquée sur les électrodes du transistor à grille flottante d'une cellule mémoire (non représentée) et du courant ID circulant entre le drain et la source de ce transistor dans le cas d'un effacement puis d'une programmation de la cellule mémoire.

Dans l'exemple, on choisit un courant IDECH0 égal IREF et un courant IDECH1 égal à 40*IREF. On suppose par ailleurs que le signal MODE est actif.

Un circuit de commutation (non représenté) est connecté entre le circuit 200 selon l'invention et la cellule mémoire ; il permet d'appliquer la tension VPP sur l'une ou l'autre des électrodes du transistor à grille flottante de la cellule mémoire selon l'opération (effacement ou programmation) à effectuer.

Lors de la phase d'effacement de la cellule mémoire (figure 3a), la tension VPP est appliquée sur la grille de commande du transistor à grille flottante, et une tension nulle est appliquée sur son drain et sur sa source.

Initialement, la tension RAMPest nulle, de même que les potentiels TOP et BOT aux pôles du condensateur C. La tension VPP est égale à VDD.

Lorsque le signal BUSY est activé, la tension RAMP croît selon une pente constante (car ICH est constant) et atteint un maximum. VPP commence à croître lorsque RAMP est supérieure à VDD et elle suit les variations de RAMP. Les tension RAMP, VPP restent ensuite constantes pendant un temps quasi nul (et donc non représenté figure 3a) correspondant à la décharge du condensateur C avec le courant IDECH1. Puis elles chutent respectivement à 0 V et à VDD.

Le courant ID circulant entre le drain et la grille flottante du transistor de mémorisation est nul lorsque VPP est inférieure à la tension tunnel VT du transistor. Puis ID chute brutalement (figure 3a, courbe en pointillés) pour atteindre une valeur minimale lorsque la tension VPP atteint son maximum, puis ID revient à 0 lorsque VPP atteint la valeur VDD.La tension tunnel est dans l'exemple de 10 V.

Lors de la programmation de la cellule mémoire (figure 3b), la tension VPP est appliquée sur le drain du transistor à grille flottante, une tension nulle est appliquée sur sa grille de commande et sa source est laissée à un potentiel flottant. Les tensions RAMP, VPP évoluent de manière similaire à leur évolution dans le cas d'un effacement de la cellule. Le courant ID évolue par contre en sens contraire.

Le circuit de la figure 2 est amélioré par l'ajout d'un circuit de détection de tension 210 et par la modification du circuit de charge 206.

Le circuit de détection de tension 210 mesure le niveau de la tension d'effacement ou de programmation VPP, et fournit un signal CHARGE ayant les caractéristiques suivantes :
CHARGE est actif si VPP < VS
CHARGE est inactif si VPP ≥ VS,
où VS est une tension de seuil. VS est choisie légèrement inférieure à la tension tunnel VT du transistor à grille flottante d'une cellule mémoire.

Le circuit de charge modifié comprend une borne d'entrée connectée à la borne de sortie du générateur de courant 205 pour recevoir le courant IREF, une borne d'entrée connectée à une borne de sortie du circuit de détection de tension 210 pour recevoir le signal CHARGE, et une borne de sortie connectée comme précédemment au pôle BOT du condensateur C. Le circuit de charge 206 produit un courant de charge ICH à partir du courant de référence IREF, en fonction du signal CHARGE. Le courant ICH a les propriétés suivantes :
ICH = ICH0 si CHARGE est actif
ICH = ICH1 si CHARGE est inactif

Le courant ICH0 est choisi supérieur au courant ICH1. Dans un exemple, ICH0 = 10*ICH1.

Ainsi, lorsque la tension VPP est inférieure à VS, le courant ICH0 est produit, qui permet de charger rapidement le condensateur C, et donc d'augmenter rapidement la valeur des tensions RAMP, VPP, selon une première pente (réf. 311, 321, figure 3a, 3b, courbes en tirets). Puis, lorsque la tension VPP atteint et dépasse la tension de seuil VS, le courant produit par le circuit de charge prend la valeur ICH1, de sorte que la croissance des tensions RAMP, VPP est limitée (312, 322). On obtient ainsi des tensions RAMP, VPP, croissant selon deux pentes, une première pente rapide 311, 321, et une deuxième pente lente 312, 322. Les variations de ID sont bien sûr modifiées en conséquence.

Cette amélioration permet ainsi de conserver aux tensions RAMP, VPP une croissance limitée en particulier lorsque la tension tunnel est atteinte : ceci est important car les oxydes du transistor à grille flottante sont particulièrement fragiles au delà de cette valeur. Cette amélioration permet par contre de réduire encore de manière importante le temps de montée des tensions RAMP, VPP, et en conséquence, les temps de programmation et/ ou d'effacement de la cellule mémoire.

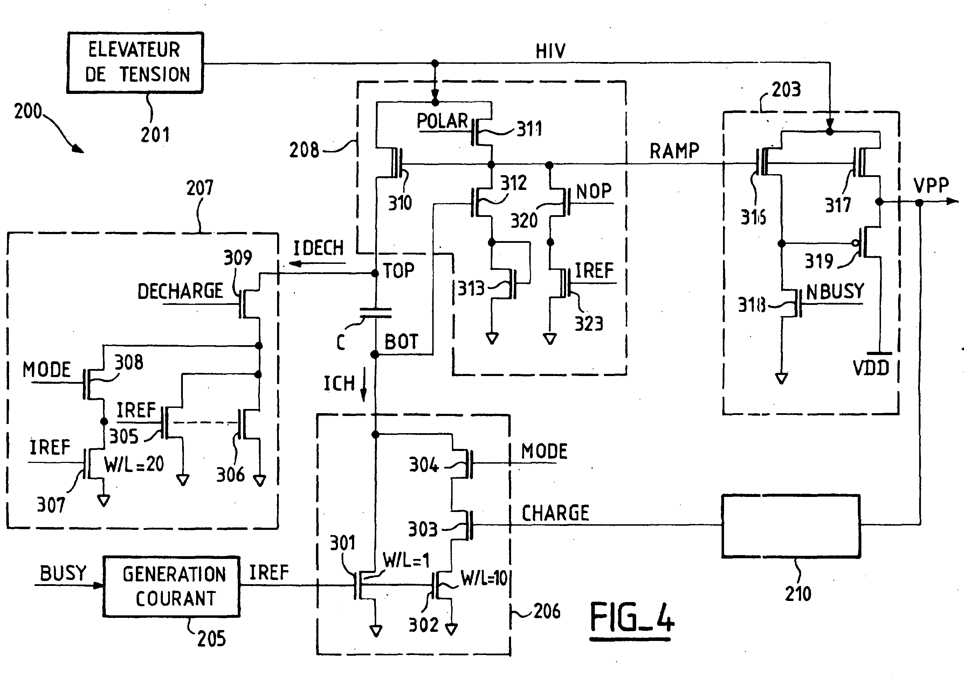

La figure 4 détaille des modes de réalisation de certains éléments du circuit 200 de production d'une tension d'effacement ou de programmation de la figure 2.

Le circuit de charge 206 comprend un transistor N 301, dont une source est connectée à une masse du circuit. Le transistor reçoit sur sa grille le courant de référence IREF et un courant ICH1 circule entre son drain et sa source.

Ainsi réalisé, le circuit 206 permet la charge du condensateur C à courant constant ICH1, pour fournir une tension RAMP croissante selon une seule pente.

Selon le mode amélioré de réalisation, le circuit de charge 206 comprend également deux transistors N 302, 303. Les drains des transistors 301, 303 sont connectés ensemble au pôle BOT du condensateur C. La source du transistor 303 est connectée au drain du transistor 302 dont la source est connectée à la masse. Enfin, le courant IREF est appliqué sur la grille du transistor 302 et le signal de commande CHARGE est appliqué sur la grille du transistor 303.

Le transistor 302 est par exemple de taille (en terme de rapport longueur / largeur de grille W/L) neuf fois supérieure à celle du transistor 301, de sorte que, lorsqu'il est passant (c'est-à-dire lorsque le signal CHARGE est actif), le courant qui circule entre son drain et sa source est neuf fois supérieur au courant ICH1 circulant entre le drain et la source du transistor 301. Ce courant s'ajoute à ICH1 pour former le courant ICH0.

Rappelons que le signal CHARGE a les caractéristiques suivantes :
CHARGE est actif si VPP < VS
CHARGE est inactif si VPP ≥ VS,

Ainsi amélioré, le circuit 206 permet de charger le condensateur C :
- lorsque VPP < VS, avec le courant ICH = ICH0, ICH0 étant égal au courant ICH1 circulant dans le transistor 301 additionné du courant circulant dans les transistors 302, 303, et
- lorsque VPP ≥ VS, avec le courant ICH = ICH1.

On a donc dans ce cas une phase de croissance des tensions RAMP, VPP en deux pentes : une première pente rapide lorsque VPP < VS, suivie d'une deuxième pente lente, lorsque VPP ≥ VS.

Le circuit 206 peut encore être amélioré par l'ajout d'un transistor 304, dont un drain est connecté au drain du transistor 301 et dont une source est connectée au drain du transistor 303, le transistor 304 recevant le signal de commande MODE sur sa grille de commande. Le transistor 304 permet à l'utilisateur du circuit 200 de choisir une croissance des tensions RAMP, VPP selon une seule pente ou selon deux pentes, en fixant le signal de commande MODE.

Le circuit de décharge 207 comprend trois transistors 307, 308, 309 de type N. Le transistor 309 a un drain connecté au pôle TOP du condensateur C et le signal de commande DECHARGE est appliqué sur sa grille, permettant ainsi d'activer le circuit de décharge 207.

Le transistor 308 a un drain connecté à la source du transistor 309 et une source connectée à un drain du transistor 307, dont la source est connectée à la masse du circuit. Le signal de commande MODE est appliqué sur la grille du transistor 308 et le courant de référence IREF est appliqué sur la grille du transistor 307. Le transistors 307, 308 sont passants uniquement si le signal MODE est actif.

Le circuit 207 comprend également X transistors N associés en parallèle représentés par les transistors 305, 306, leurs drains étant connectés ensemble à la source du transistor 309 et leurs sources étant connectés ensemble à la masse du circuit. Le courant IREF est appliqué sur les grilles communes des transistors 305, 306.

On notera que les X transistors associés en parallèle sont équivalents à un unique transistor de taille (W/L) égale à la somme des tailles de tous les transistors de l'ensemble 305, 306, c'est-à-dire de taille X fois supérieure si les transistors 305, 306 sont identiques.

La taille des transistors 305, 306 d'une part et 307 d'autre part, est choisie de sorte que :
- les transistors 305, 306 sont choisis de sorte que le courant IDECH0 qui les traverse lorsqu'ils sont passants soit assez faible, pour permettre la formation d'un plateau sur le signal RAMP de durée suffisamment longue pour assurer la programmation complète et certaine d'une cellule mémoire,
- le transistor 307 est choisi de taille beaucoup plus importante, de sorte que le plateau de la tension RAMP soit de durée réduite, voire nulle.

Par exemple, si les transistors 305, 306 sont équivalents à un transistor de taille W/L = 1, on peut choisir un transistor 307 de taille W/L = 10 à 100. Avec ce choix, la durée du plateau des tensions RAMP, VPP est divisée par 10 à 100 lorsque MODE est actif, elle devient ainsi négligeable par rapport à la durée de la phase ascendante de ces mêmes tensions.

Le circuit 207 permet de décharger le condensateur C :
- lorsque MODE est inactif, la décharge s'effectue avec le courant ICH = IDECH0 , IDECH0 étant égal à la somme des courants circulant dans les transistors 305, 306, et
- lorsque MODE est actif, la décharge s'effectue avec le courant ICH = IDECH1, IDECH1 étant égal à la somme des courants circulant dans tous les transistors 305, 306, additionné du courant circulant dans le transistor 307.

Ainsi, selon le choix de l'utilisateur (MODE actif ou inactif), le plateau des tensions RAMP, VPP est soit d'une durée habituelle, équivalente à celle d'un circuit connu, soit de durée réduite voire nulle.

Le générateur de rampe 208 comprend quant à lui un transistor natif 310, quatre transistors de type N 311 à 313, 320, et un transistor N natif 323. Le générateur de rampe est réalisé selon un schéma connu ; il fournit la tension RAMP à partir de la tension HIV, et des potentiels TOP, BOT aux bornes du condensateur C.

Le transistor 310 a un drain connecté à une borne de sortie du circuit élévateur de tension 201 pour recevoir la haute tension continue HIV, et une source connectée au pôle TOP du condensateur C. Le drain du transistor 311 est connecté à la borne de sortie du circuit 201 et sa source est connectée au drain du transistor 312 dont la source est connecté au drain et à la grille du transistor 313. La source du transistor 313 est connectée à la masse. La grille du transistor 312 est connectée au pôle BOT du condensateur C, la grille du transistor 310 est connectée à la source du transistor 311, et un signal de commande POLAR est appliqué sur la grille du transistor 311. POLAR est ici égal à l'inverse de BUSY.

Le drain du transistor 320 est connecté à la grille du transistor 316 et sa source est connectée au drain du transistor 323 dont la source est connectée à la masse. Un signal de commande NOP est appliqué sur la grille de commande du transistor 320 et le courant IREF est appliqué sur la grille du transistor 323.

NOP est un signal de commande ayant les caractéristiques suivantes :
- si une seule opération (d'effacement ou de programmation) est envisagée, alors NOP est inverse du signal BUSY.
- si deux (ou plusieurs) opérations successives sont envisagées, par exemple une opération d'effacement suivie d'une opération de programmation, alors le signal BUSY est actif depuis le début de la première opération jusqu'à la fin de la deuxième opération ; le signal NOP est quant à lui inverse du signal BUSY avant et pendant la première opération, pendant et après la deuxième opération, mais il devient ponctuellement égal au signal BUSY entre les deux opérations. Les signaux NOP, BUSY permettent ainsi de commander différemment les éléments du circuit 200, lorsque plusieurs opérations sont exécutées successivement, comme on le verra mieux par la suite.

Les transistors 320, 323 ont ainsi pour fonction de ramener la tension RAMP à 0 à la fin d'une étape d'effacement et / ou de programmation.

Le circuit de mise en forme 203 comprend deux transistors N natifs 316, 317, un transistor N 318, et un transistor P 319. Le circuit 203 est réalisé selon un schéma connu ; il produit la tension d'effacement ou de programmation VPP à partir de la tension RAMP.

La tension HIV est appliquée sur les drains des transistors 316, 317 qui sont connectés ensemble. La tension RAMP est appliquée sur les grilles des transistors 316, 317 connectées ensemble. Le drain du transistor 318 est connecté à la source du transistor 316, sa source est connectée à la masse et le signal NBUSY est appliqué sur sa grille de commande.

La source du transistor 319 et connectée à la source du transistor 317, sa grille est connectée au drain du transistor 318 et la tension d'alimentation VDD est appliquée sur son drain. La tension VPP est fournie sur la source du transistor 317.

En pratique, le circuit 203 joue le rôle d'un circuit de commutation, qui fournit soit la tension RAMP si la tension RAMP est supérieure à la tension d'alimentation VDD, soit la tension d'alimentation VDD si la tension RAMP est inférieure à la tension VDD.

Les diagrammes des figures 5a à 5i montrent l'évolution des signaux de commande et des tensions en différents points du circuit de la figure 3 lorsqu'une opération d'effacement suivie d'une opération de programmation est réalisée, dans le cas suivant :
- le signal MODE est actif (égal à 1),
- HIV = 20 V
- VDD = 5 V
- VS = 10 V
- ICH0 = IREF et ICH1 = 10*IREF
- IDECH1 = 40*IREF et IDECH0 = IREF
- IREF = 100 nA

Initialement, les tensions HIV, RAMP, VPP, TOP, BOT sont nulles, les signaux de commande NOP, CHARGE, DECHARGE sont actifs, égaux à 1, et le signal BUSY est inactif, égal à 0.

Le circuit 200 est activé par le signal BUSY, qui passe à 1 à l'instant t0 = 0. Les signaux NOP, DECHARGE passent à 0. La tension HIV grimpe immédiatement à sa valeur nominale. La tension VPP grimpe immédiatement à VDD, et la tension BOT grimpe également à sa valeur maximale, légèrement inférieure à HIVmax.

Comme CHARGE est actif, le courant de charge ICH est égal à ICH1, la charge rapide du condensateur C démarre, la tension TOP commence à grimper linéairement selon une pente rapide et la tension RAMP grimpe également selon la même pente par couplage capacitif entre la grille et la source du transistor 310. Comme RAMP < VDD, la tension VPP est égale à VDD, imposée par les transistors 317, 319.

Lorsque RAMP atteint la valeur VDD (au bout de 0.02 ms environ), la tension VPP devient égale à la tension RAMP, et les tensions VPP, RAMP, TOP continuent à grimper selon la même pente..

Lorsque VPP atteint VS = 10 V, le détecteur 210 désactive le signal CHARGE : le transistor 303 se bloque et le courant de charge diminue fortement : il prend la valeur ICH0. Les tensions TOP, RAMP, VPP continuent à croître, mais selon une pente beaucoup plus faible. Le potentiel BOT reste égal à sa valeur maximale.

Il arrive un moment où le potentiel TOP atteint une valeur maximale, égale à environ la tension HIV moins la chute de tension dans le transistor 310. Le condensateur continue à se charger le potentiel BOT diminue. Lorsque le potentiel BOT devient inférieur à la tension de seuil du transistor 312, le potentiel BOT annule le courant de charge ICH et rend le signal DECHARGE actif : le circuit de décharge est activé et le courant IDECH = IDECH1 est produit, qui décharge rapidement le condensateur C.

Le potentiel BOT atteint une valeur nulle, le potentiel TOP diminue rapidement. Par contre, la tension RAMP reste constante, égale à sa valeur maximale car le transistor 312 est bloqué.

Lorsque le potentiel TOP devient inférieur à un potentiel seuil, il rend le signal DECHARGE inactif, la décharge du condensateur C est stoppée, si elle n'est pas déjà terminée. A cet instant précis, le signal NOP, passe à 1 brièvement. En conséquence, la tension RAMP chute à 0 (transistor 320 passant) et la tension VPP chute à VDD puisque RAMP est inférieure à VDD (rôle des transistors 317, 319).

L'opération d'effacement se termine et l'opération de programmation commence alors : les signaux évoluent de manière similaire pour cette opération.

## Revendications

1. Circuit (200) de production d'une tension d'effacement ou de programmation d'une cellule mémoire, comprenant un condensateur (C), et un circuit de décharge (207) connecté à une première borne (TOP) du condensateur (C)) pour décharger le condensateur (C),
le circuit de décharge (207) du condensateur (C) comprenant :
- un premier transistor (309), dont un drain est connecté à la première borne (TOP) du condensateur (C), pour activer le circuit de décharge (207) lorsqu'un signal de décharge (DECHARGE) est appliqué sur la grille de commande du premier transistor (309),
- une branche de décharge lente (305, 306) connectée à la source du premier transistor (309), pour produire un faible courant de décharge (IDECH0) du condensateur (C) lorsque le signal de décharge (DECHARGE) est reçu, et
**caractérisé en ce que** le circuit de décharge (207) comprend en outre :
- une branche de décharge rapide (307, 308), connectée à la source du premier transistor (309), pour produire un fort courant de décharge (IDECH1) du condensateur (C) lorsque le signal de décharge (DECHARGE) et un signal de sélection (MODE) d'un mode de fonctionnement sont reçus simultanément.

2. Circuit selon la revendication 1, **caractérisé en ce que** la branche de décharge lente comprend un deuxième transistor (305, 306), dont un drain est connecté à la source du premier transistor (309) et dont une source est connectée à une masse du circuit, le faible courant de décharge étant proportionnel à un courant de référence (IREF) appliqué sur la grille de commande du deuxième transistor.

3. Circuit selon la revendication 2, **caractérisé en ce que** le deuxième transistor comprend une série de transistors (305, 306), comprenant un ou plusieurs transistors associés en parallèle, un drain commun étant connecté à la source du premier transistor (309) et une source commune étant connectée à une masse du circuit, le fort courant de décharge étant proportionnel au courant de référence (IREF) appliqué sur une grille commune, le fort courant de décharge (IDECH1) étant supérieur au faible courant de décharge (IDECH0).

4. Circuit selon la revendication 1, **caractérisé en ce que** la branche de décharge rapide comprend :
- un troisième transistor (308), dont un drain est connecté à la source du premier transistor (309), le signal de sélection de mode (MODE) étant appliqué sur la grille de commande du troisième transistor (308), et
- un quatrième transistor (307), dont un drain est connecté à une source du troisième transistor (308) et dont une source est connectée à la massé du circuit, le courant de référence (IREF) étant appliqué sur la grille de commande du quatrième transistor.

5. Circuit selon la revendication 4, **caractérisé en ce que** le quatrième transistor (307) comprend une série de transistors, comprenant un ou plusieurs transistors associés en parallèle, un drain commun étant connecté à la source du troisième transistor (308) et une source commune étant connectée à une masse du circuit, le courant de référence (IREF) étant appliqué sur une grille commune.

6. Circuit selon l'une des revendications 4 ou 5, **caractérisé en ce que** la taille du quatrième transistor (307) est supérieure à la taille du deuxième transistor (305, 306).

7. Circuit selon la revendication 6, **caractérisé en ce que** la taille du quatrième transistor (307) est 10 à 100 fois supérieure à la taille du deuxième transistor.

8. Circuit selon l'une des revendications 1 à 7, comprenant un circuit de charge (206) connecté à une deuxième borne (BOT) du condensateur (C), pour charger le condensateur (C), le circuit (200) étant **caractérisé en ce que** le circuit de charge (206) comprend :
- une branche de charge lente (301) connectée à la deuxième borne (BOT) du condensateur (C), pour produire un faible courant de charge (ICHO) lorsque un signal d'activation (BUSY) est reçu, et
- une branche de charge rapide (302, 303, 304), connectée à la deuxième borne (BOT) du condensateur (C), pour produire un fort courant de charge (ICH1) du condensateur (C) si le signal de sélection (MODE) de mode et un signal de niveau de tension (CHARGE) sont reçus simultanément, le signal de niveau de tension (CHARGE) indiquant qu'une tension d'effacement ou de programmation (VPP) fournie par le circuit (200) de production d'une tension d'effacement ou de programmation est inférieure à une tension de seuil (VS).

9. Circuit selon la revendication 8, **caractérisé en ce que** la branche de charge rapide comprend :
- un cinquième transistor (302) dont une source est connectée à la masse,
- un sixième transistor (303), dont une source est connectée à un drain du cinquième transistor (302), le signal de niveau de tension (CHARGE) étant appliqué sur une grille de commande du sixième transistor (303), et
- un septième transistor (304), dont une source est connectée à un drain du sixième transistor (303), et dont un drain est connecté à la deuxième borne (BOT) du condensateur (c), le signal de sélection de mode (MODE) étant appliqué sur une grille de commande du septième transistor (304).

10. Circuit selon l'une des revendications 1 à 9, **caractérisé en ce qu**'il comprend également :
- un circuit (208) de génération d'une rampe de tension, pour produire une rampe de tension (RAMP), à partir des potentiels sur la première borne (TOP) et la deuxième borne (BOT) du condensateur (C), et
- un circuit de mise en forme (203), comprenant un huitième transistor (317), une haute tension (HIV) étant appliquée sur une borne du huitième transistor (317), et la tension d'effacement ou de programmation (VPP) étant fournie sur une autre borne du huitième transistor (317),
le huitième transistor étant de type N natif.

11. Procédé de production d'une tension d'effacement ou de programmation d'une cellule mémoire, au cours duquel on charge un condensateur (C) en appliquant un courant de charge sur une deuxième borne (BOT) au cours d'une première étape, puis on décharge le condensateur (C) en appliquant un courant de décharge sur une première borne (TOP) du condensateur (C) au cours d'une deuxième étape,
le procédé étant **caractérisé en ce que,** au cours de la deuxième étape, le courant de décharge prend une faible valeur (IDECH0) ou une forte valeur (IDECH1) supérieure à la faible valeur (IDECH0), en fonction d'un mode (MODE) de fonctionnement.

## Claims

1. A circuit (200) for the production of a voltage for the erasure or programming of a memory cell, comprising a capacitor (C), and a discharge circuit (207) connected to a first terminal (TOP) of the capacitor (C) to discharge the capacitor (C),
the circuit (207) to discharge the capacitor (C) comprising:
• a first transistor (309), a drain of which is connected to the first terminal (TOP) of the capacitor (C), to activate the discharge circuit (207) when a discharge signal (DECHARGE) is applied to the control gate of the first transistor (309),
• a slow discharge arm (305, 306) connected to the source of the first transistor (309) to produce a low current (IDECH0) for discharging the capacitor (C) when the discharge signal (DECHARGE) is received,
wherein the discharge circuit (207) also comprises
• a fast discharge arm (307, 308), connected to the source of the first transistor (309), to produce a high current (IDECH1) for the fast discharging of the capacitor (C) when the discharge signal (DECHARGE) and an operating mode selection signal (MODE) are received simultaneously.

2. A circuit according to claim 1, wherein the slow discharge arm (305, 306) comprises a second transistor, having a drain connected to the source of the first transistor (309) and having a source connected to a ground of the circuit, the low discharge current being proportional to a reference current (IREF) applied to the control gate of the second transistor.

3. A circuit according to claim 2, wherein the second transistor comprises a series of transistors (305, 306), comprising one or more parallel-mounted transistors, a common drain being connected to the source of the first transistor (309) and a common source being connected to a ground of the circuit, the high discharge current being proportional to the reference current (IREF) applied to a common gate, the high discharge current (IDECHI) being higher than the low discharge current (IDECH0).

4. A circuit according to claim 1, wherein fast discharge arm comprises for example:
a third transistor (308), having a drain connected to the source of the first transistor (309), the mode selection signal (MODE) being applied to the control gate of the third transistor (308), and
a fourth transistor (307), having a drain connected to a source of the third transistor (308) and having a source connected to the ground of the circuit, the reference current (IREF) being applied to the control gate of the fourth transistor.

5. A circuit according to claim 4, wherein the fourth transistor (307) comprises a series of transistors, comprising one or more parallel-mounted transistors, a common drain being connected to the source of the third transistor (308) and a common source being connected to the ground of the circuit, the reference current (IREF) being applied to a common gate.

6. A circuit according to any of the claims 4 or 5, wherein size of the fourth transistor (307) is greater than the size of the second transistor (305, 306).

7. A circuit according to claim 6, wherein the size of the fourth transistor (307) is 10 to 100 times greater than the size of the second transistor (305, 306).

8. A circuit according to any of the claims 1 to 7, comprising a charging circuit (206), connected to a second terminal (BOT) of the capacitor (C), to charge the capacitor (C), wherein the charging circuit (206) comprises:
a slow charging arm (301) connected to the second terminal (BOT) of the capacitor (C), to produce a low charging current (ICHO) when an activation signal (BUSY) is received, and
a fast charging arm (302, 303, 304), connected to the second terminal (BOT) of the capacitor (C), to produce a high charging current (ICH 1) for the capacitor (C) if the mode selection signal (MODE) and a voltage level signal (CHARGE) are received simultaneously, the voltage level signal indicating that an erasure or programming voltage (VPP) given by the circuit (200) for the production of an erasure or programming voltage is below a threshold voltage (VS).

9. A circuit according to claim 8, wherein the fast charging arm comprises:
a fifth transistor (302) having one source connected to the ground,
a sixth transistor (303), having a source connected to a drain of the fifth transistor (302), the voltage level signal (CHARGE) being applied to the control gate of the sixth transistor (303), and
a seventh transistor (304), having a source connected to a drain of the sixth transistor (303), and a drain connected to a second terminal (BOT) of the capacitor (C), the mode selection signal (MODE) being applied to a control gate of the seventh transistor (304).

10. A circuit according to any of the claims 1 to 9, also comprising
a circuit (208) for the generation of a voltage ramp, to produce a voltage ramp (RAMP) from potentials at the first terminal (TOP) and the second terminal (BOT) of the capacitor (C), and
a shaping circuit (203) comprising an eighth transistor (317), a high voltage (HIV) being applied to a terminal of the eighth transistor (317), and the erasure or programming voltage (VPP) being given at another terminal of the eighth transistor (317), the eighth transistor being of the N native type.

11. A method for the production of voltage for the erasure or programming of a memory cell, during which a capacitor (C) is charged by the application of a charging current to a second terminal (BOT) during a first step, and then the capacitor (C) is discharged by applying a discharge current to a first terminal (TOP) of the capacitor (C) during a second step,
wherein, during the second step, the discharge current takes a low value (IDECH0) or a high value (IDECHI) greater than a low value (IDECHO), as a function of a mode (MODE) of operation.

## Patentansprüche

1. Schaltung (200) zur Erzeugung einer Lösch- oder Programmierspannung einer Speicherzelle, einen Kondensator (C) und eine Entladeschaltung (207) umfassend, die an einen ersten Anschluss (TOP) des Kondensators (C) angeschlossen ist, um den Kondensator (C) zu entladen,
wobei die Entladeschaltung (207) des Kondensators (C) umfasst:
- einen ersten Transistor (309), dessen Drain an den ersten Anschluss (TOP) des Kondensators (C) angeschlossen ist, um die Entladeschaltung (207) zu aktivieren, wenn ein Entladesignal (DECHARGE) an das Steuergate des ersten Transistors (309) angelegt wird,
- einen Langsamentladungszweig (305, 306), der mit der Source des ersten Transistors (309) verbunden ist, um einen niedrigen Entladungsstrom (IDECH0) des Kondensators (C) zu erzeugen, wenn das Entladesignal (DECHARGE) empfangen wird, und
**dadurch gekennzeichnet, dass** die Entladeschaltung (207) außerdem umfasst :
- einen Schnellentladungszweig (307, 308), der an die Source des ersten Transistors (309) angeschlossen ist, um einen starken Entadungsstrom (IDECH1) des Kondensators (C) zu erzeugen, wenn das Entladesignal (DECHARGE) und ein Betriebsartauswahlsignal (MODE) gleichzeitig empfangen werden.

2. Schaltung nach Patentanspruch 1, **dadurch gekennzeichnet, dass** der Langsamentladungszweig einen zweiten Transistor (305, 306) umfasst, dessen Drain mit der Source des ersten Transistors (309) verbunden ist und dessen Source mit der Masse der Schaltung verbunden ist, wobei der niedrige Entadungsstrom zu einem Bezugsstrom (IREF) proportional ist, der am Steuergate des zweiten Transistors anliegt.

3. Schaltung nach Patentanspruch 2, **dadurch gekennzeichnet, dass** der zweite Transistor eine Reihe von Transistoren (305, 306) umfasst, die einen oder mehrere parallelgeschaltete Transistoren umfasst, wobei ein gemeinsamer Drain an die Source des ersten Transistors (309) angeschlossen ist und eine gemeinsame Source an der Masse der Schaltung anliegt, wobei der starke Entladungsstrom dem Bezugsstrom (IREF) proportional ist, der an ein gemeinsames Gate angelegt ist, wobei der starke Entladungsstrom (IDECH1) höher ist, als der niedrige Entladungsstrom (IDECH0).

4. Schaltung nach Patentanspruch 1, **dadurch gekennzeichnet, dass** der Schnellentladungszweig umfasst:
- einen dritten Transistor (308), dessen Drain an die Source des ersten Transistors (309) angeschlossen ist, während das Betriebsartauswahlsignal (MODE) an das Steuergate des dritten Transistors (308) angelegt wird, und
- einen vierten Transistor (307), dessen Drain an eine Source des dritten Transistors (308) angeschlossen ist und dessen Source an der Masse der Schaltung anliegt, wobei der Bezugsstrom (IREF) an das Steuergate des vierten Transistors angelegt wird.

5. Schaltung nach Patentanspruch 4, **dadurch gekennzeichnet, dass** der vierte Transistor (307) eine Reihe von Transistoren umfasst, die einen oder mehrere parallelgeschaltete Transistoren umfasst, wobei ein gemeinsamer Drain an die Source des dritten Transistors (308) angeschlossen ist und eine gemeinsame Source an der Masse der Schaltung anliegt, wobei der Bezugsstrom (IREF) an ein gemeinsames Gate angelegt ist.

6. Schaltung nach einem der Patentansprüche 4 oder 5, **dadurch gekennzeichnet, dass** die Größe des vierten Transistors (307) die Größe des zweiten Transistors (305, 306) übersteigt.

7. Schaltung nach Patentanspruch 6, **dadurch gekennzeichnet, dass** der vierte Transistor (307) 10- bis 100-mal größer ist, als der zweite Transistor.

8. Schaltung nach einem der Patentansprüche 1 bis 7, eine Ladeschaltung (206) umfassend, die an einen zweiten Anschluss (BOT) des Kondensators (C) angeschlossen ist, um den Kondensator (C) zu laden, wobei die Schaltung (200) **dadurch gekennzeichnet ist, dass** die Ladeschaltung (206) umfasst:
- einen Langsamladungszweig (301), der an den zweiten Anschluss (BOT) des Kondensators (C) angeschlossen ist, um einen niedrigen Ladestrom (ICHO) zu erzeugen, wenn ein Aktivierungssignal (BUSY) empfangen wird, und
- einen Schnellladungszweig (302, 303, 304), der an den zweiten Anschluss (BOT) des Kondensators (C) angeschlossen ist, um einen starken Ladestrom (ICH1) des Kondensators (C) zu erzeugen, wenn das Betriebsartauswahlsignal (MODE) und ein Spannungspegelsignal (CHARGE) gleichzeitig empfangen werden, wobei das Spannungspegelsignal (CHARGE) angibt, dass eine Lösch- oder Progammierspannung (VPP), die die Schaltung (200) zur Erzeugung einer Lösch- oder Progammierspannung ausgibt, geringer ist, als eine Schwellenspannung (VS).

9. Schaltung nach Patentanspruch 8, **dadurch gekennzeichnet, dass** der Schnellladungszweig umfasst:
- einen fünften Transistor (302), dessen Source an Masse anliegt,
- einen sechsten Transistor (303), dessen Source an einen Drain des fünften Transistors (302) angeschlossen ist, während das Spannungspegelsignal (CHARGE) an das Steuergate des sechsten Transistors (303) angelegt ist, und
- einen siebten Transistor (304), dessen Source an den Drain des sechsten Transistors (303) angeschlossen ist und dessen Drain an den zweiten Anschluss (BOT) des Kondensators (C) angeschlossen ist, während das Betriebsartauswahlsignal (MODE) an ein Steuergate des siebten Transistors (304) angelegt ist.

10. Schaltung nach einem der Patentansprüche 1 bis 9, **dadurch gekennzeichnet, dass** sie ebenfalls umfasst:
- eine Sägezahnspannungsschaltung (208) zur Erzeugung eines Sägezahnspannungsanstiegs (RAMP) aus den Potentialen am ersten Anschluss (TOP) und am zweiten Anschluss (BOT) des Kondensators (C) und
- eine Formungsschaltung (203), die einen achten Transistor (317) umfasst, wobei eine hohe Spannung (HIV) an einen Anschluss des achten Transistors (317) angelegt wird und die Lösch- und Programmierspannung (VPP) an einem anderen Anschluss des achten Transistors (317) ausgegeben wird,
wobei der achte Transistor vom Typ mit N-Eigenleitung ist.

11. Verfahren zur Erzeugung einer Lösch- oder Programmierspannung für eine Speicherzelle, in dessen Verlauf ein Kondensator (C) geladen wird, indem während eines ersten Schrittes ein Ladestrom an einen zweiten Anschluss (BOT) angelegt und dann der Kondensator (C) entladen wird, indem während eines zweiten Schrittes ein Entladungsstrom an einen ersten Anschluss (TOP) des Kondensators (C) angelegt wird,
wobei das Verfahren **dadurch gekennzeichnet ist, dass** der Entladungsstrom während des zweiten Schrittes in Abhängigkeit von einer Betriebsart (MODE) einen niedrigen Wert (IDECH0) annimmt oder einen hohen Wert (IDECH1), der höher ist, als der niedrige Wert (IDECH0).
